# EUROPÄISCHE PATENTSCHRIFT

(11) **EP 2 459 611 B1**
(45) Veröffentlichungstag und Bekanntmachung des Hinweises auf die Patenterteilung: **04.09.2013**
(21) Anmeldenummer: 10734460.8
(22) Anmeldetag: 20.07.2010
(51) Int. Cl.: C08G 18/10, H01L 41/22

(54) **ELEKTROMECHANISCHER WANDLER MIT EINEM POLYMERELEMENT AUF BASIS EINER MISCHUNG AUS POLYISOCYANAT UND ISOCYANAT-FUNKTIONELLEM PREPOLYMER UND EINER VERBINDUNG MIT MINDESTENS ZWEI ISOCYANATREAKTIVEN HYDROXYGRUPPEN**
Electromechanical converter with a polymer element on the basis of a mixture of polyisocyanate and isocyanate-functional prepolymer and a connection with at least two isocyanate reactive hydroxyl groups
Convertisseur électromécanique doté d'un élément polymère basé sur un mélange en polyisocyanate et de pré-polymères fonctionnels avec de l'isocyanate et sur une liaison dotée d'au moins deux groupes hydroxy réactifs à isocyanate

(30) Priorität: 31.07.2009 EP 09009911
(43) Veröffentlichungstag der Anmeldung: 06.06.2012
(73) Patentinhaber: Bayer Intellectual Property GmbH, 40789 Monheim (DE)
(72) Erfinder: JENNINGER, Werner, 50677 Köln (DE); DÖRR, Sebastian, 40593 Düsseldorf (DE); WAGNER, Joachim, 51061 Köln (DE)
(74) Vertreter: BIP Patents
(86) Internationale Anmeldenummer: PCT/EP2010/004435
(87) Internationale Veröffentlichungsnummer: WO 2011/012244

(56) Entgegenhaltungen:
- WO-A1-98/17995
- DE-A1- 10 241 295
- US-A- 5 047 162
- US-A- 5 977 685
- US-B1- 6 847 153

## Beschreibung

Die vorliegende Erfindung betrifft einen elektromechanischen Wandler, insbesondere einen elektromechanischen Sensor, Aktuator und/oder Generator, der ein Polymerelement aufweist, welches aus einer Reaktionsmischung, umfassend ein Polyisocyanat und ein Polyisocyanat-Prepolymer und eine Verbindung mit mindestens zwei isocyanatreaktiven Hydroxyruppen, erhältlich ist. Darüber hinaus betrifft die vorliegende Erfindung ein Verfahren zur Herstellung eines derartigen elektromechanischen Wandlers, sowie die Verwendung eines derartigen Polymerelements als Aktuator, Sensor und/oder Generator. Ferner betrifft die vorliegende Erfindung eine elektronische und/oder elektrische Vorrichtung, welche einen erfindungsgemäßen elektromechanischen Wandler umfasst, sowie die Verwendung eines erfindungsgemäßen elektromechanischen Wandlers in einer elektronischen und/oder elektrischen Vorrichtung.

Ein elektromechanischer Wandler wandelt elektrische Energie in mechanische Energie um und umgekehrt. Elektromechanische Wandler können daher als Sensoren, Aktuatoren und/oder Generatoren eingesetzt werden.

Der grundsätzliche Aufbau eines solchen Wandlers basiert auf einer Schicht aus einem elektroaktiven Polymer, welche beidseitig mit Elektroden beschichtet ist. Dabei wird unter einem elektroaktiven Polymer ein Polymer verstanden, welches sein Volumen und/oder seine Form in Abhängigkeit von einer daran anliegenden Spannung ändert und/oder welches durch eine Volumen- und/oder Formänderung eine Spannung erzeugen kann.

Die WO 01/06575 A1 offenbart, dass beispielsweise Silikonelastomere, Acrylelastomere, Polyurethane, thermoplastische Elastomere, Polytetrafluorethylen umfassende Copolymere, Fluorelastomere und Silikon- und Acryl-Gruppen umfassende Polymere diese elektromechanischen Eigenschaften aufweisen können.

Die unveröffentlichte europäische Patentanmeldung EP08013648.4 offenbart elektromechanische Wandler, die aus Polyisocyanaten und/oder Polyisocyanat-Prepolymeren und Diaminofunktionellen Verbindungen hergestellt werden. Die unveröffentlichte europäische Patentanmeldung EP08018936.8 offenbart elektromechanische Wandler, die aus Lösungen von wenigstens einem Polyurethan in organischen Lösemitteln hergestellt werden. Diese Systeme haben den Nachteil, dass durch den hohen Gehalt organischer Lösemittel nur beschränkte Möglichkeiten zur Beschichtung existieren, da diverse Anforderungen an die Arbeitssicherheit, beispielsweise zum Schutz der Mitarbeiter und zur Vermeidung von Zündquellen, eingehalten werden müssen. Auch aus ökologischen Gründen ist ein System ohne große Anteile organischer Lösemittel wünschenswert.

US 5 977 685 offenbart elektromechanischer Wandler, die aus Polyisocyantprepolymeren und hydroxylgruppen enthaltende Verbindungen hergestellt werden.

Darüber hinaus weisen herkömmliche, in elektromechanischen Wandlern eingesetzte, Polymere häufig nachteilige Eigenschaften auf, die gegebenenfalls die Funktionsfähigkeit der elektromechanischen Wandler negativ beeinflussen können. Hierunter fallen schlechte mechanische und andere Eigenschaften, insbesondere nachteilige Dehnungseigenschaften, eine geringe Isolationswirkung, insbesondere niedrige Durchbruchsfeldstärken und hohe elektrische Leitfähigkeiten, eine schlechte Prozessierbarkeit und hohe Materialkosten. Insbesondere kann durch herkömmlicherweise in elektromechanischen Wandlern eingesetzte Polymere, beispielsweise Silikone, eine Kombination der gewünschten Eigenschaftsmerkmale nicht in einem Material erzielt werden. Auch die in der EP08013648.4 und der EP08018936.8 zur Herstellung des Wandlers eingesetzten Polyurethane weisen weniger optimale mechanische Eigenschaften auf, da es sich bei diesen Polyurethanen um solche mit linearen Polymerketten handelt, was insbesondere weniger optimale elastomere Eigenschaften zur Folge hat.

Aufgabe der vorliegenden Erfindung war es daher, einen elektromechanischen Wandler zur Verfügung zu stellen, der verbesserte Eigenschaften aufweist und die Nachteile bekannter elektromechanischer Wandler überwindet.

Im Rahmen der vorliegenden Erfindung wurde gefunden, dass diese Aufgabe durch einen elektromechanischen Wandler, der ein Polymerelement enthält, welches aus einer Reaktionsmischung umfassend ein Polyisocyanat und ein Polyisocyanat-Prepolymer und eine Verbindung mit mindestens zwei isocyanatreaktiven Hydroxygruppen, insbesondere hydroxygruppen-haltige Polymere, erhältlich ist, gelöst wird. Die Definition und Unterscheidung der Begriffe "Polyisocyanat" und "Polyisocyanat-Prepolymer" wird unten angegeben. Es handelt sich jeweils um Verbindung, die mindestens zwei freie Isocyanat-Gruppen aufweisen.

Gegenstand der vorliegenden Erfindung ist daher ein elektromechanischer Wandler, der mindestens zwei Elektroden und mindestens ein elektroaktives Polymerelement aufweist, wobei das Polymerelement zwischen zwei Elektroden angeordnet ist und insbesondere mindestens eine der Elektroden kontaktiert, und wobei das Polymerelement erfindungsgemäß aus einer, beispielsweise filmbildenden, Reaktionsmischung umfassend die folgenden Komponenten
A) ein Polyisocyanat,
B) ein Polyisocyanat-Prepolymer
C) eine Verbindung mit mindestens zwei isocyanatreaktiven Hydroxygruppen
erhältlich ist.

Als Polyisocyanat und Komponente A) eignen sich erfindungsgemäß beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'-und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Uretdion-, Isocyanurat-, Biuret-, lminooxadiazindion- oder Oxadiazintrionstruktur enthaltende Verbindungen basierend auf den genannten Diisocyanaten geeignete Bausteine der Komponente A.

Die als Komponente B) einsetzbaren Polyisocyanat-Prepolymere können durch Umsetzung von einem oder mehreren Diisocyanaten mit einem oder mehreren hydroxyfunktionellen, insbesondere polymeren, Polyolen gegebenenfalls unter Zusatz von Katalysatoren sowie Hilfs- und Zusatzstoffen erhalten werden. Des Weiteren können zusätzlich Komponenten zur Kettenverlängerung, wie beispielsweise mit primären und/oder sekundären Aminogruppen (NH₂- und/oder NH-funktionelle Komponenten) für die Bildung des Polyisocyanat-Prepolymers eingesetzt werden.

Im Rahmen der vorliegenden Erfindung kann Komponente C) grundsätzlich eine Verbindung mit mindestens zwei isocyanatreaktiven Hydroxygruppen sein. Beispielsweise kann Komponente C) ein Polyol mit mindestens zwei isocyanatreaktiven Hydroxygruppen sein.

Dabei werden im Rahmen der vorliegenden Erfindung die Begriffe "ein" und "eine" im Zusammenhang mit den Komponenten A), B) und C) nicht als Zahlwörter, sondern als unbestimmter Artikel verwendet.

Das aus den erfindungsgemäßen Komponenten hergestellte Polymerelement weist eine gute mechanische Festigkeit und hohe Elastizität auf. Weiterhin weist das Polymerelement zusätzlich gute elektrische Eigenschaften; wie Durchbruchsfeldstärke und Dielektrizitätskonstante auf und kann daher vorteilhaft in einem elektromechanischen Wandler eingesetzt werden.

Wenn eine mechanische Beanspruchung auf einen derartigen Wandler ausgeübt wird, so deformiert sich der Wandler beispielsweise entlang seiner Dicke und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

In einer Ausführungsform des erfindungsgemäßen elektromechanischen Wandlers kann die Komponente A) in der Reaktionsmischung ein Diisocyanat-basierendes Polyisocyanat mit einer Funktionalität ≥ 2 mit Uretdion-, Isocyanurat-, Biuret-, Iminooxadiazindion- oder Oxadiazintrionstruktur oder einer Mischung hieraus sein, wobei solche mit einer Isocyanuratstruktur besonders bevorzugt sind..

In einer Ausführungsform des erfindungsgemäßen elektromechanischen Wandlers kann die Komponente A) ein Polyisocyanat oder ein Polyisocyanatgemisch mit einer mittleren NCO-Funktionalität von 2 bis 4 mit ausschließlich aliphatisch oder cycloaliphatisch gebundenen Isocyanatgruppen sein. Bevorzugt handelt es sich um Polyisocyanate oder Polyisocyanatgemische der vorstehend genannten Art mit Uretdion-, Isocyanurat-, Biuret-, Iminooxadiazindion- oder Oxadiazintrionstruktur sowie Mischungen daraus und einer mittleren NCO-Funktionalität der Mischung von 2 bis 4, bevorzugt von 2 bis 2,6 und besonders bevorzugt von 2 bis ,2,4.

Besonders bevorzugt können als Komponente A) Polyisocyanate auf der Basis von Hexamethylendiisocyanat, Isophorondiisocyanat oder die isomeren Bis-(4,4'-isocyanatocyclohexyl)methane sowie Mischungen der vorgenannten Diisocyanate eingesetzt werden.

Das Polyisocyanat Prepolymer als Komponente B) kann bevorzugt aus der Umsetzung von polymeren Polyolen und aliphatischen Diisocyanaten erhältlich sein. Bevorzugt sind dabei als Komponente B) Polyisocyanat Prepolymere auf Basis von Polypropylengkylol als Polyol und Hexamethylendiisocyanat als aliphatischem Diisocyanat.

Hydroxyfunktionelle, polymere Polyole für die Umsetzung zum Polyisocyanat Prepolymer B) können erfindungsgemäß beispielsweise auch Polyesterpolyole, Polyacrylatpolyole, Polyurethanpolyole, Polycarbonatpolyole, Polyetherpolyole, Polyesterpolyacrylatpolyole, Polyurethanpolyacrylatpolyole, Polyurethanpolyesterpolyole, Polyurethanpolyetherpolyole, Polyurethanpolycarbonatpolyole und/oder Polyesterpolycarbonatpolyole sein. Diese können zur Herstellung des Polyisocyanat-Prepolymers einzeln oder in beliebigen Mischungen untereinander eingesetzt werden.

Geeignete Polyesterpolyole zur Herstellung der Polyisocyanat-Prepolymere B) können Polykondensate aus Di- sowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Beispiele für geeignete Diole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimetylolbenzol oder Trishydroxyethylisocyanurat oder Mischungen davon eingesetzt werden.

Als Dicarbonsäuren können dabei Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dimethylbernsteinsäure eingesetzt werden. Als Säurequelle können auch die entsprechenden Anhydride verwendet werden.

Sofern die mittlere Funktionalität des zu veresternden Polyols ≥ 2 ist, können zusätzlich auch Monocarbonsäuren, wie Benzoesäure und Hexancarbonsäure mit verwendet werden.

Bevorzugte Säuren sind aliphatische oder aromatische Säuren der vorstehend genannten Art. Besonders bevorzugt sind dabei Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Ebenfalls können zur Herstellung der Polyisocyanat-Prepolymere B) Hyroxylgruppen aufiveisende Polycarbonate, beispielsweise Polycarbonatpolyole, bevorzugt Polycarbonatdiole, eingesetzt werden. Beispielsweise können diese ein zahlenmittleres Molekulargewichten Mₙ von 400 g/mol bis 8000 g/mol, bevorzugt von 600 g/mol bis 3000 g/mol eingesetzt werden. Diese können durch Reaktion von Kohlensäurederivaten, wie Diphenylcarbonat, Dimethylcarbonat oder Phosgen, mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A oder lactonmodifizierte Diole der vorstehend genannten Art oder Mischungen davon.

Bevorzugt enthält die Diolkomponente dabei von 40 Gewichtsprozent bis 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten, werden im Rahmen der vorliegenden Erfindung in bekannter Weise derart gewählt, dass die Summe 100 Gewichtsprozent nicht überschreitet, insbesondere 100 Gewichtsprozent ergibt.

Hydroxylgruppen aufweisende Polycarbonate, insbesondere Polycarbonatpolyole, sind bevorzugt linear gebaut.

Ebenfalls können zur Herstellung der Polyisocyanat-Prepolymere B) Polyetherpolyole eingesetzt werden. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Bevorzugte Komponenten zur Herstellung der Polyisocyanat-Prepolymere B) sind Polypropylenglykol, Polytetramethylenglykolpolyether und Polycarbonatpolyole beziehungsweise deren Mischungen, wobei Polypropylenglykol besonders bevorzugt ist.

Dabei können polymere Polyole mit einem zahlenmittleren Molekulargewicht Mₙ von 400 g/mol bis 8000 g/mol, bevorzugt von 400 g/mol bis 6000 g/mol und besonders bevorzugt von 600 g/mol bis 3000 g/mol eingesetzt werden. Diese weisen bevorzugt eine OH-Funktionalität von 1,5 bis 6, besonders bevorzugt von 1,8 bis 3, ganz besonders bevorzugt von 1,9 bis 2,1 auf.

Neben den genannten polymeren Polyolen können auch kurzkettige Polyole bei der Herstellung der Polyisocyanat-Prepolymere B) eingesetzt werden. Beispielsweise kann Ethylenglykol, Diethylenglykol, Triethylenglykol, 1,2-Propandiol, 1,3-Propandiol, 1,4-Butandiol, 1,3-Butylenglykol, Cyclohexandiol, 1,4-Cyclohexandimethanol, 1,6-Hexandiol, Neopentylglykol, Hydrochinondihydroxyethylether, Bisphenol A (2,2-Bis(4-hydroxyphenyl)propan), hydriertes Bisphenol A (2,2-Bis(4-hydroxycyclohexyl)propan), Trimethylolpropan, Trimethylolethan, Glycerin oder Pentaerythrit oder eine Mischung davon eingesetzt werden.

Geeignet sind auch Esterdiole des genannten Molekulargewichtsbereichs wie α-Hydroxybutyl-ε-hydroxy-capronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können zur Herstellung der Polyisocyanat-Prepolymere B) auch monofunktionelle isocyanatreaktive hydroxylgruppenhaltige Verbindungen eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

Zur Herstellung der Polyisocyanat-Prepolymere B) können in einer Ausführungsform der Erfindung Diisocyanate mit den Polyolen bei einem Verhältnis der Isocyanatgruppen zu Hydroxylgruppen (NCO/OH-Verhältnis) von 2:1 bis 20:1, beispielsweise von 8:1, umgesetzt werden. Dabei können Urethan- und/oder Allophanatstrukturen gebildet werden. Ein Anteil an nicht umgesetzten Polyisocyanaten kann anschließend abgetrennt werden. Hierfür kann beispielsweise eine Dünnschichtdestillation verwendet, wobei restmonomerenarme Produkte mit Restmonomergehalten von beispielsweise ≤ 1 Gewichtsprozent, bevorzugt ≤ 0,5 Gewichtsprozent, besonders bevorzugt ≤ 0,1 Gewichtsprozent, erhalten werden. Die Reaktionstemperatur kann dabei von 20 °C bis 120 °C, bevorzugt von 60 °C bis 100 °C, betragen. Gegebenenfalls können während der Herstellung Stabilisatoren wie Benzoylchlorid, Isophthaloylchlorid, Dibutylphosphat, 3-Chlorpropionsäure oder Methyltosylat zugesetzt werden.

Weiterhin können NH₂- und/oder NH-funktionelle Komponenten zusätzlich zur Kettenverlängerung bei der Herstellung der Polyisocyanat-Prepolymere B) eingesetzt werden.

Erfindungsgemäß geeignete Komponenten zur Kettenverlängerung sind organische. Di- oder Polyamine. Beispielsweise können Ethylendiamin, 1,2- Diaminopropan, 1,3-Diaminopropan, 1,4-Diaminobutan, 1,6-Diaminohexan, lsophorondiamin, Isomerengemisch von 2,2,4- und 2,4,4-Trimethylhexa- methylendiamin, 2-Methylpentamethylendiamin, Diethylentriamin, Diaminodicyclohexylmethan oder Dimethylethylendiamin oder Mischungen davon eingesetzt werden.

Darüber hinaus können auch Verbindungen, die neben einer primären Aminogruppe auch sekundäre Aminogruppen oder neben einer Aminogruppe (primär oder sekundär) auch OH-Gruppen aufweisen, zur Herstellung der Polyisocyanat-Prepolymere B) eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Die als Komponente B) erfindungsgemäß eingesetzten Polyisocyanat-Prepolymere oder deren Mischungen können bevorzugt eine mittlere NCO-Funktionalität von 1,8 bis 5, besonders bevorzugt 2 bis 3,5 und ganz besonders bevorzugt 2 bis 2,5 aufweisen.

Die Komponenten A) und B können erfindungsgemäß bevorzugt zunächst miteinander gemischt und dann die Mischung aus A) und B) mit C umgesetzt werden.

In einer weiteren Ausführungsform kann die Komponente C) ein Polyamin oder ein Polyol mit mindestens zwei isocyanatreaktiven Hydroxygruppen sein. Bevorzugt kann als Komponente C) ein polymeres Polyol eingesetzt werden. Erfindungsgemäß ist weiterhin bevorzugt, dass die Komponente C ein Polymer mit 2 bis 4 Hydroxygruppen, ganz besonders bevorzugt ein Polypropylengkylol mit 2 bis 3 Hydroxygruppen ist.

Als Komponente C) können erfindungsgemäß hydroxyfunktionelle, insbesondere polymere, Polyole, beispielsweise Polyetherpolyole eingesetzt werden. Beispielsweise eignen sich Polytetramethylenglykolpolyether, wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden.

Erfindungsgemäß bevorzugt haben die polymeren Polyole aus C) eine besonders enge Molekulargewichtsverteilung, d.h. eine Polydispersität (PD = Mw/Mn) von 1,0 bis 1,5 und/oder eine OH-Funktionalität von größer 1,9. Bevorzugt weisen die genannten Polyetherpolyole eine Polydispersität von 1,0 bis 1,5 und eine OH-Funktionalität von größer 1,9 auf, besonders bevorzugt größer oder gleich 1,95 auf.

Solche Polyetherpolyole sind in an sich bekannter Weise durch Alkoxylierung von geeigneten Starter-Molekülen, insbesondere unter Verwendung von Doppelmetallcyanid-Katalysatoren (DMC-Katalyse) herstellbar. Diese Methode ist zum Beispiel in der Patentschrift US 5,158,922 und der Offenlegungsschrift EP 0 654 302 A1 beschrieben.

Die erfindungsgemäße Reaktionsmischung für das Polymerelement kann durch Mischen der Komponenten A), B) und C) erhalten werden. Das Verhältnis von Isocyanatreaktiven Hydroxygruppen zu freien Isocyanatgruppen ist dabei vorzugsweise von 1:1,5 bis 1,5:1 besonders bevorzugt von 1:1,02:bis 1:0,95.

Vorzugsweise besitzt zumindest eine der Komponenten A, B oder C eine Funktionalität von ≥ 2,0, bevorzugt von ≥ 2,5 bevorzugt von ≥ 3,0, um in das Polymerelement eine Verzweigung oder eine Vernetzung einzuführen. Funktionalität bezieht sich bei Komponente A und B auf die mittlere Anzahl von NCO-Gruppen pro Molekül bzw. bei Kom ponente C auf die mittlere Anzahl von OH-Gruppen pro Molekül. Diese Verzeigung bzw. Vernetzung bewirkt bessere mechanische Eigenschaften und bessere elastomere Eigenschaften, insbesondere auch bessere Dehnungseigenschaften, für den Einsatzzweck als elektromechanischer Wandler.

Im Rahmen der vorliegenden Erfindung kann es sich bei dem Polymerelement um eine Polymerschicht, insbesondere einen Polymerfilm, eine Polymerfolie oder eine Polymerbeschichtung handeln. Beispielsweise kann die Polymerschicht eine Schichtdicke von 0,1 µm bis 1500 µm, beispielsweise von 1 µm bis 500 µm, insbesondere von 5 µm bis 200 µm, vorzugsweise von 10 µm bis 100 µm, aufweisen.

Das erfindungsgemäße Polymerelement kann vorteilhafterweise eine gute mechanische Festigkeit und hohe Elastizität aufweisen. Insbesondere kann das erfindungsgemäße Polymerelement eine maximale Spannung von ≥ 0,2 MPa, insbesondere von 0,4 MPa bis 50 MPa, und eine maximale Dehnung von ≥250%, insbesondere von ≥350%, aufweisen. Darüber hinaus kann das erfindungsgemäße Polymerelement im Gebrauchsdehnungsbereich von 100 % bis 200 % eine Spannung von 0,1 MPa bis 1 MPa, beispielsweise von 0,1 MPa bis 0,8MPa, insbesondere von 0,1 MPa bis 0,3 MPa, aufweisen (Bestimmung nach DIN 53504). Ferner kann das erfindungsgemäße Polymerelement ein Elastizitätzmodul bei einer Dehnung von 100 % von 0,1 MPa bis 10 MPa, beispielsweise von 0,2 MPa bis 5 MPa, aufweisen (Bestimmung nach DIN EN 150672 1-1).

Das erfindungsgemäße Polymerelement kann weiterhin vorteilhafterweise gute elektrische Eigenschaften aufweisen; diese können für die Durchbruchsfeldstärke nach ASTM D 149 und für die Messungen der Dielektrizitätskonstante ASTM D 150 bestimmt werden.

Ein weiterer Gegenstand der vorliegenden Erfindung ist ein Verfahren zur Herstellung eines erfindungsgemäßen elektromechanischen Wandlers, in dem
- mindestens zwei Elektroden bereitgestellt werden, und
- ein Polymerelement durch Umsetzung einer Reaktionsmischung umfassend die folgenden Komponenten
   A) ein Polyisocyanat
   B) ein Polyisocyanat-Prepolymer und
   C) eine Verbindung mit mindestens zwei isocyanatreaktiven Hydroxygruppen, bereitgestellt wird, und
- das Polymerelement zwischen zwei Elektroden angeordnet wird.

Insbesondere kann das Polymerelement dabei derart zwischen zwei Elektroden angeordnet werden, dass das Polymerelement mindestens eine der Elektroden kontaktiert.

Im Rahmen einer Ausführungsform der vorliegenden Erfindung kann das elektroaktive Polymerelement derart zwischen zwei Elektroden angeordnet werden, dass die Elektroden auf gegenüberliegenden Seiten des Polymerelements an dieses angrenzen. Beispielsweise kann das Polymerelement beidseitig mit Elektroden beschichtet sein.

Im Rahmen einer bevorzugten Ausführungsform des erfindungsgemäßen Verfahrens kann das Polymerelement durch Auftragen der Reaktionsmischung auf mindestens eine der Elektroden und Umsetzen der Reaktionsmischung bereitgestellt werden. Das Auftragen der Reaktionsmischung kann beispielsweise durch Rakeln, Streichen, Gießen, Schleudern, Sprühen oder Extrusion erfolgen. Es ist im Rahmen der vorliegenden Erfindung ebenso möglich, die Elektroden und das Polymerelement in separaten Schritten herzustellen und nachträglich zusammen zu fügen.

Im Rahmen einer bevorzugten Ausführungsform des erfindungsgemäßen Verfahrens wird die Reaktionsmischung getrocknet und/oder getempert. Das Trocknen kann dabei in einem Temperaturbereich von 0 °C bis 200 °C, beispielsweise für 0,1 min bis 48 h, insbesondere für 6 h bis 18 h erfolgen. Das Tempern kann beispielsweise in einem Temperaturbereich von 80 °C bis 250 °C, beispielsweise für 0,1 min bis 24 h, erfolgen.

In einer Ausgestaltung des erfindungsgemäßen Verfahrens kann das eingesetzte Equivalent-Verhältnis der Isocyanatgruppen aus A) zu den Isocyanatgruppen aus B) zwischen ≥ 1:10 bis ≤ 10:1, besonders bevorzugt ≥ 1:5 zu ≤ 5:1 und ganz besonders bevorzugt ≥ 1:3 zu ≤ 3:1. Das mit bereitgestellte Polymerelement kann bei einem solchen gewählten Verhältnis für die Reaktionsmischung besonders vorteilhafte mechanische und elektrische Eigenschaften aufweisen.

Die Geschwindigkeit bei 23 °C, bis eine weitgehende Vernetzung und Aushärtung der Mischung aus A), B) und C) erreicht ist, kann typischerweise von 1 s bis 300 min, bevorzugt von 1 min bis 20 min, besonders bevorzugt von 1 min bis 10 min, betragen. Durch Katalysatoren kann die Aushärtung beschleunigt werden. In einer bevorzugten Ausführungsform sind ≥ 50 Molprozent der isocyanatreaktiven Gruppen zur Aushärtung der Komponenten A) und B) Polyetherpolyole. Im Rahmen einer besonders bevorzugten Ausführungsform der vorliegenden Erfindung werden Komponenten A) und B) ausschließlich mit Polyetherpolyolen und ganz besonders bevorzugt ausschließlich mit Polypropylenglykol gehärtet.

Bevorzugte Gewichtsanteile in Bezug auf die fertige Reaktionsmischung aus A), B), C) und gegebenenfalls weiteren Anteilen sind:
1 bis 30 Gew.-Anteile an A), bevorzugt 4 bis 20 Gew.-Anteile
1 bis 50 Gew.-Anteile an B) bevorzugt 25 bis 40 Gew.-Anteile
10 bis 70 Gew.-Anteile an C) bevorzugt 30 bis 65 Gew.-Anteile, sowie gegebenenfalls
0 bis 50 Gew.-Anteile an weiteren Hilfs- Zusatzstoffe bzw. Additiven bevorzugt 0 bis 20 Gew.-Anteile. Die oben stehenden Anteile sind dabei jeweils so zu bemessen, dass die Summe aller Gew.-Anteile 100 ergibt.

Die Reaktionsmischung, umfassend die Komponenten A), B) und C) kann einerseits direkt auf die Elektroden aufgetragen werden und dort aushärten. Andererseits kann auch zunächst ein Film oder eine Folie aus der Reaktionsmischung hergestellt, gegebenenfalls vollständig ausgehärtet, und anschließend mit den Elektroden kombiniert werden. Dabei können Klebstoffe zum Einsatz kommen oder es kann die Klebefähigkeit der Reaktionsmischung selbst ausgenutzt werden.

Der Auftrag der erfindungsgemäßen filmbildenden Reaktionsmischungen kann nach allen an sich bekannten Applikationsformen erfolgen, genannt seien beispielsweise Rakeln, Streichen, Gießen, Schleudern, Sprühen oder Extrusion.

Die Reaktionsmischung kann neben den Komponenten A), B) und C) zusätzlich auch Hilfs- und Zusatzstoffe enthalten. Beispiele für solche Hilfs- und Zusatzstoffe sind Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Die Reaktionsmischung kann neben den Komponenten A), B) und C) zusätzlich auch Füllstoffe enthalten. Diese Füllstoffe können beispielsweise die Dielektrizitätskonstante des Polymerelements regulieren. Vorzugsweise umfasst die Reaktionsmischung Füllstoffe zur Erhöhung der Dielektrizitätskonstanten wie Füllstoffe mit einer hohen Dielektrizitätskonstanten. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb der Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Im Rahmen der vorliegenden Erfindung können Additive zur Erhöhung der Dielektrizitätskonstanten und/oder der elektrischen Durchschlagsfeldstärke auch nach der Verfilmung noch zugesetzt werden. Dies kann beispielsweise durch Erzeugung einer oder mehrerer weiterer Schichten oder durch Durchdringung des Polymerelements beispielsweise durch Eindiffusion in das Polymerelement erfolgen.

Darüber hinaus ist auch ein mehrschichtiger Auftrag der Reaktionsmischung mit gegebenenfalls zwischengelagerten Trocknungsschritten möglich.

Das Trocknen und Fixieren der Reaktionsmischung kann bei Temperaturen von 30 °C, vorzugsweise von 10 °C bis 200 °C, erfolgen. Dabei kann ein beschichtetes Substrat über eine geheizte Oberfläche, beispielsweise eine Walze, geführt werden. Der Auftrag sowie die Trocknung können jeweils diskontinuierlich oder kontinuierlich durchgeführt werden. Vorzugsweise ist das Verfahren gänzlich kontinuierlich.

Das erfindungsgemäße Polymerelement kann mit weiteren funktionellen Schichten, beispielsweise leitfähigen Schichten, Barriereschichten gegen Lösemittel und Gase, und/oder Haftschichten versehen werden. Dies kann einseitig oder beidseitig geschehen, in einer Schicht oder in mehreren Schichten übereinander, durch vollständige oder durch flächig partielle Beschichtung des Polymerelements.

Als Trägermaterialien für die Herstellung eines Polymerfilms aus der Reaktionsmischung eignen sich insbesondere Glas, Trennpapier, Folien und Kunststoffe, von denen der erzeugte Polymerfilm gegebenenfalls einfach entfernt werden kann.

Die Verarbeitung der einzelnen Schichten aus der Reaktionsmischung kann durch Gießen oder händisch sowie maschinell durchgeführtes Rakeln erfolgen. Drucken, Siebdrucken, Spritzen, Sprühen und Tauchen sind hierfür ebenso mögliche Verarbeitungstechniken.

Nach dem Vernetzen kann ein als Polymerfilm, Polymerfolie oder Polymerbeschichtung ausgebildetes erfindungsgemäßes Polymerelement eine Schichtdicke von 0,1 µm bis 1500 µm, beispielsweise von 1 µm bis 500 µm, insbesondere von 5 µm bis 200 µm, vorzugsweise von 10 µm bis 100 µm, aufweisen.

Ein weiterer Gegenstand der vorliegenden Erfindung ist die Verwendung eines Polymerelements, erhältlich aus einer Reaktionsmischung umfassend die folgenden Komponenten
A) ein Polyisocyanat
B) ein Polyisocyanat-Prepolymer und
C) eine Verbindung mit mindestens zwei isocyanatreaktiven Hydroxygruppen,
als elektromechanisches Element, beispielsweise als Sensor, Aktuator und/oder Generator, insbesondere als elektromechanisches Element in einem Sensor, Aktuator und/oder Generator.

Eine weiterer Gegenstand der vorliegenden Erfindung ist eine elektronische und/oder elektrische Vorrichtung, insbesondere ein Baustein, Automat, Instrument oder eine Komponente, umfassend einen erfindungsgemäßen elektromechanischen Wandler.

Ferner betrifft die vorliegende Erfindung die Verwendung eines erfindungsgemäßen elektromechanischen Wandlers in einer elektronischen und/oder elektrischen Vorrichtung, insbesondere in einem Aktor, Sensor oder Generator. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von Wasserwellenenergie, insbesondere Meereswellenenergie, in elektrische Energie.

Zum Aufbau eines erfindungsgemäßen Wandlers können die erfindungsgemäßen Polymerelemente beidseitig mit Elektroden, wie beispielsweise in WO 01/06575 beschrieben, beschichtet werden. Dieser grundsätzliche Aufbau kann vorteilhaft in unterschiedlichsten Konfigurationen zur Herstellung von Sensoren, Aktuatoren und/oder Generatoren eingesetzt werden. Vorteilhafterweise zeigen die Polymerelemente für die erfindungsgemäßen elektromechanischen Wandler besonders gute mechanische und elektrische Eigenschaften auf. Die erfindungsgemäßen elektromechanischen Wandler können in verschiedensten Anwendungen eingesetzt werden.

Durch die nachfolgend aufgeführten Beispiele soll die Erfindung weiter erläutert werden, ohne auf diese beschränkt zu sein.

### Beispiele:

Sofern nicht abweichend gekennzeichnet, beziehen sich alle Prozentangaben auf das Gewicht.

Sofern nicht abweichend vermerkt, beziehen alle analytischen Messungen auf Temperaturen von 23 °C.

NCO-Gehalte wurden, wenn nicht ausdrücklich anders erwähnt, volumetrisch gemäß DIN-EN ISO 11909 bestimmt.

Die angegebenen Viskositäten wurden mittels Rotationsviskosimetrie nach DIN 53019 bei 23 °C mit einem Rotationsviskosimeter der Firma Anton Paar Germany GmbH, Deutschland, Helmuth-Hirth-Str. 6, 73760 Ostfildern bestimmt.

Die Einarbeitung von Füllstoffen in die erfindungsgemäßen Dispersionen geschah mit einem Speedmixer (Modell 150 FV der Firma Hauschild & Co KG, Deutschland, Waterkamp 1, 59075 Hamm).

Messungen der Filmschichtdicken wurden mit einem mechanischen Taster der Firma Dr. Johannes Heidenhain GmbH, Deutschland, Dr.-Johannes-Heidenhain-Str. 5, 83301 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit in [MPa] und der Bruchdehnung in [%] noch die Spannung in [MPa] bei 100% und 200% Dehnung bestimmt.

Die Bestimmung der bleibenden Dehnung wurde mittels einer Zugmaschine Zwicki der Firma Zwick / Roell, ausgestattet mit einer Kraftmessdose des Gesamtmessbereiches von 50N, an einem S2-Stab der zu untersuchenden Probe ausgeführt. Bei dieser Messung wird die Probe mit einer Geschwindigkeit von 50mm / min bis zu n* 50% gedehnt, nach erreichen dieser Deformation wird die Probe auf Kraft = 0 N entlastet und die dann noch vorhandene Dehnung bestimmt. Direkt anschließend startet der nächste Messzyklus mit n=n+1; der Wert für n wird solange gesteigert, bis die Probe reißt. Hier wird nur der Wert für 50% Deformation gemessen.

Die Bestimmung des Creep wird ebenfalls auf der Zugmaschine Zwicki ausgeführt; die Instrumentierung entspricht dabei dem Versuch zur Bestimmung der bleibenden Dehnung. Als Probekörper wird hierbei eine streifenförmige Probe der Dimension 60 x 10 mm² eingesetzt, die mit einem Klemmenabstand von 50 mm eingespannt wird. Nach einer sehr schnellen Deformation auf 55 mm wird diese Deformation für die Dauer von 30 min konstant gehalten und während dieser Zeit der Kraftverlauf bestimmt. Der Creep nach 30 min ist der prozentuale Abfall der Kraft, bezogen auf den Anfangswert direkt nach der Deformation auf 55 mm.

Messungen der Dielektrizitätskonstante gemäß ASTM D 150-98 wurden mit einem Messaufbau der Firma Novocontrol Technologies GmbH & Co. KG, Obererbacher Straße 9, 56414 Hundsangen, Deutschland (Messbrücke : Alpha-A Analyzer, Messkopf: ZGS Active Sample Cell Test Interface) mit einem Durchmesser der Probekörper von 20 mm ausgeführt. Untersucht wurde dabei ein Frequenzbereich von 10⁷ Hz bis 10⁻² Hz. Als Maß für die Dielektrizitätskonstante des untersuchten Materials wurde der Realteil der Dielektrizitätskonstante bei 10⁻² Hz gewählt.

Die Bestimmung der Durchbruchsfeldstärke gemäß ASTM D 149-97a wurde mit einer Hochspannungsquelle Modell LNC 20000-3pos der Firma Heinzinger, Anton-Jakob-Str. 4 in 83026 Rosenheim, Deutschland, und einem eigenkonstruierten Probenhalter am DKI (Deutsches Kunststoffinstitut, Schloßgartenstr. 6 in 64289 Darmstadt, Deutschland) durchgeführt. Der Probenhalter kontaktiert die homogen dicken Polymerproben mit nur geringer mechanische Vorbelastung und verhindert, dass der Bediener in Kontakt mit der Spannung kommt. Die nicht vorgespannte Polymerfolie wird in diesem Aufbau - zur Isolation gegen Durchschläge in der Luft in Siliconöl - mit steigender Spannung statisch belastet, bis ein elektrischer Durchbruch durch die Folie erfolgt. Messergebnis ist die beim Durchbruch erreichte Spannung, bezogen auf die Dicke der Polymerfolie in [V/µm].

### Verwendete Substanzen und Abkürzungen:

| | |
|---|---|
| Desmodur® N 3300 : | Isocyanurat auf Basis von Hexamethylendiisocyanat, NCO-Gehalt 21,8 ± 0,3 % (nach DIN EN ISO 11 909), Viskosität bei 23 °C 3000 ± 750 mPa·s, Bayer MaterialScience AG, Leverkusen, DE, (Komponente A) |
| Desmodur® XP 2410 | Niedrigviskoses, aliphatisches Polyisocyanat-Harz auf Basis Hexamethylendiisocyanat, NCO-Gehalt 23,5 ± 0,5 Gew.-% (DIN EN ISO 11 909) Viskosität bei 23 °C 730 ± 100 mPa·s, Bayer MaterialScience AG, Leverkusen, DE, (Komponente A) |
| Desmodur® XP 2599 | Aliphatisches, Ethergruppen enthaltendes Prepolymer auf Basis Hexamethylen-1,6-diisocyanat (HDI), Isocyanatgehalt 6 ± 0,5 % (DIN EN ISO 11 909), Viskosität bei 23 °C 2.500 ± 500 mPa·s, Bayer MaterialScience AG, Leverkusen, DE, (Komponente B) |
| DBTDL | Dibutyl-Zinn-Dilaurat der Firma E-Merck KGaA, Frankfurter Str. 250, D-64293 Darmstadt, Germany |

### Beispiel 1

### Herstellung eines di-isocyanatfunktionellen Polyisocyanat-Prepolymers als Komponente B)

1300 g Hexamethylen-1,6-diisocyanat (HDI), 1,3 g Benzoylchlorid und 1,3 g para-Toluolsulfonsäuremethylester wurden in einem 4 Liter Vierhalskolben unter Rühren vorgelegt. Innerhalb von 3 Stunden fügte man bei 80°C 1456 g eines difunktionellen Polypropylenglykol-Polyethers mit einem zahlenmittleren Molekulargewicht von 2000 g/mol hinzu und rührte 1 Stunde bei gleicher Temperatur nach. Anschließend wurde durch Dünnschichtdestillation bei 130°C und 0,1 Torr das überschüssige HDI abdestilliert, im Vorlagekolben befand sich 1 g Chlorpropionsäure. Das erhaltene NCO-Prepolymer hatte einen NCO-Gehalt von 3,23% und einer Viskosität von 1650 mPas (25°C).

### Vergleichsbeispiel V1:

### Herstellung eines nicht erfindungsgemäßen Polymerelements

Die eingesetzten Rohstoffe wurden nicht separat entgast. 10 g Desmodur XP 2599 (Komponente B) wurde mit 28,1 g eines trifunktionellen Polypropylenglykol-polyethylenglykol-Polyethers mit einem zahlenmittleren Molekulargewicht von 6000 g/mol und einem Anteil an Ethylenoxid-Einheiten von 0 Gew.-% (Komponente C) und mit 0,028 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V2:

### Herstellung eines nicht erfindungsgemäßen Polymerelements

Die eingesetzten Rohstoffe wurden nicht separat entgast. 10 g Desmodur XP 2599 (Komponente B) wurde mit 28,06 g eines difunktionellen Polypropylenglykol-polyethylenglykol-Polyethers mit einem zahlenmittleren Molekulargewicht von 4000 g/mol und einem Anteil an Ethylenoxid-Einheiten von 0 Gew.-% (Komponente C) und mit 0,028g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V3:

### Herstellung eines nicht erfindungsgemäßen Polymerelements

Die eingesetzten Rohstoffe wurden nicht separat entgast. 3,91 g Desmodur N3300 (Komponente A) wurde mit 39,88 g eines difunktionellen Polypropylenglykol-polyethylenglykol-Polyethers mit einem zahlenmittleren Molekulargewicht von 4000 g/mol und einem Anteil an Ethylenoxid-Einheiten von 0 Gew.-% (Komponente C) und mit 0,12 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V4:

### Herstellung eines nicht erfindungsgemäßen Polymerelements

Die eingesetzten Rohstoffe wurden nicht separat entgast. 3,58 g Desmodur XP2410 (Komponente A) wurde mit 39,88 g eines trifunktionellen Polypropylenglykol-polyethylenglykol-Polyethers mit einem zahlenmittleren Molekulargewicht von 6000 g/mol und einem Anteil an Ethylenoxid-Einheiten von 0 Gew.-% (Komponente C) und mit 0,12 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer. Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V5:

### Herstellung eines nicht erfindungsgemäßen Polymerelements

Die eingesetzten Rohstoffe wurden nicht separat entgast. 3,91 g Desmodur N3300 (Komponente A) wurde mit 39,88 g eines trifunktionellen Polypropylenglykol-polyethylenglykol-Polyethers mit einem zahlenmittleren Molekulargewicht von 6000 g/mol und einem Anteil an Ethylenoxid-Einheiten von 0 Gew.-% (Komponente C) und mit 0,12 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Vergleichsbeispiel V6:

### Herstellung eines nicht erfindungsgemäßen Polymerelements

Die eingesetzten Rohstoffe wurden nicht separat entgast. 10,0 g Prepolymer aus Beispiel 1 (Komponente B) wurde mit 39,88 g eines difunktionellen Polypropylenglykol-polyethylenglykol-Polyethers mit einem zahlenmittleren Molekulargewicht von 4000 g/mol und einem Anteil an Ethylenoxid-Einheiten von 0 Gew.-% (Komponente C) und mit 0,03 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5min bei 120 °C nachgetempert. Aus dieser Formulierung konnten keine Probekörper hergestellt werden.

### Erfindungsgemäßes Beispiel E1:

### Herstellung eines erfindungsgemäßen Polymerelements

Die eingesetzten Rohstoffe wurden nicht separat entgast. 3,0 g Desmodur N 3300 (Isocyanurat basierend auf HDI, Komponente A) und 7,0 g des Prepolymers aus Beispiel 1 (Komponente B) wurden in einem Polypropylen-Becher eingewogen und im Speedmixer bei 3000 Umdrehungen pro Minute für 1 Minute miteinander vermischt. Diese Mischung wurde dann mit 41,2 g eines difunktionellen Polypropylenglykol-polyethylenglykol-Polyethers mit einem zahlenmittleren Molekulargewicht von 4000 g/mol und einem Anteil an Ethylenoxid-Einheiten von 0 Gew.-% (Komponente C) mit einer Menge von 0,041 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E2:

### Herstellung eines erfindungsgemäßen Polymerelements

Die eingesetzten Rohstoffe wurden nicht separat entgast. 3,0 g Desmodur N 3300 (Isocyanurat basierend auf HDI, Komponente A) und 7,0 g des Prepolymers aus Beispiel 1 (Komponente B) wurden in einem Polypropylen-Becher eingewogen und im Speedmixer bei 3000 Umdrehungen pro Minute für 1 Minute miteinander vermischt. Diese Mischung wurde dann mit 41,2 g eines trifunktionellen Polypropylenglykol-polyethylenglykol-Polyethers mit einem zahlenmittleren Molekulargewicht von 6000 g/mol und einem Anteil an Ethylenoxid-Einheiten von 0 Gew.-% (Komponente C) mit einer Menge von 0,041 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E3:

### Herstellung eines erfindungsgemäßen Polymerelements

Die eingesetzten Rohstoffe wurden nicht separat entgast. 4,0 g Desmodur N 3300 (Isocyanurat basierend auf HDI, Komponente A) und 16,0 g des Prepolymers aus Beispiel 1 (Komponente B) wurden in einem Polypropylen-Becher eingewogen und im Speedmixer bei 3000 Umdrehungen pro Minute für 1 Minute miteinander vermischt. Diese Mischung wurde dann mit 66,16 g eines difunktionellen Polypropylenglykol-polyethylenglykol-Polyethers mit einem zahlenmittleren Molekulargewicht von 4000 g/mol und einem Anteil an Ethylenoxid-Einheiten von 20 Gew.-%, bezogen auf den Polyether, mit einer Menge von 0,132 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Erfindungsgemäßes Beispiel E4:

### Herstellung eines erfindungsgemäßen Polymerelements

Die eingesetzten Rohstoffe wurden nicht separat entgast. 1,0 g Desmodur N 3300 (Isocyanurat basierend auf HDI, Komponente A) und 9,0 g des Prepolymers aus Beispiel 1 (Komponente B) wurden in einem Polypropylen-Becher eingewogen und im Speedmixer bei 3000 Umdrehungen pro Minute für 1 Minute miteinander vermischt. Diese Mischung wurde dann mit 24,22 g eines difunktionellen Polypropylenglykol-polyethylenglykol-Polyethers mit einem zahlenmittleren Molekulargewicht von 4000 g/mol und einem Anteil an Ethylenoxid-Einheiten von 20 Gew.-%, bezogen auf den Polyether, mit einer Menge von 0,048 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

Die Proben wurden verschiedenen Messungen unterzogen. Die Ergebnisse für die nicht erfindungsgemäßen Beispiele und die Beispiele für erfindungsgemäße Polymerelemente sind in der nachfolgenden Tabelle 1 dargestellt.

**Tabelle 1: Eigenschaften der in den Beispielen V1 bis V5 und E1 bis E4 hergestellten Filme**

| Beispiel | Bruchdehnung | Zugfestigkeit | Modul bei 50 % Dehnung | Bleibende Dehnung bei 50% Dehnung | Creep nach 30 min | Dielektrizitätskonstante | Durchbruchs feldstärke (ungedehnter Zustand) |
|---|---|---|---|---|---|---|---|
| | [%] | [MPa] | [MPa] | [MPa] | [%] | | [V/µm]] |
| V1 | 107 | 0,327 | 0,275 | 0,32 | 13,5 | 25 | 20,4 |
| V2 | 125 | 0,178 | 0,134 | 0,45 | 13,9 | 16,6 | 21,3 |
| V3 | 262 | 0,28 | 0,099 | 1,71 | 30,3 | 8,6 | 25 |
| V4 | 85 | 0,63 | 0,625 | 0,65 | 10,5 | 29 | 25,4 |
| V5 | 110 | 0,70 | 0,60 | -0,24 | 6,2 | 10,8 | 33,4 |
| E1* | 364 | 0,143 | 0,040 | 1,84 | 21,3 | 8,7 | 24,6 |
| E2* | 251 | 0,392 | 0,161 | 1,76 | 20,4 | 11,6 | 18,2 |
| E3* | 211 | 0,927 | 0,497 | 1,29 | 4,7 | 2800 | 35,5 |
| E4* | 516 | 1,085 | 0,266 | 2,48 | 19,9 | 1796 | 38,6 |

| | | | | | | | |
|---|---|---|---|---|---|---|---|
| * erfindungsgemäß | | | | | | | |

Es zeigte sich bei den Versuchen, dass die erfindungsgemäßen Polymerelemente als Filme deutliche Vorteile gegenüber dem Stand der Technik bieten. Besonders nachteilig waren bei den nicht-erfindungsgemäßen Beispielen eine niedrige Bruchdehnung und ein hoher Creep.

Besonders vorteilhaft bei Einsatz der erfindungsgemäßen Filme ist die Kombination aus sehr guten mechanischen Eigenschaften wie hohe Bruchdehnung, niedriger Modul, niedrige bleibende Dehnung, niedriger Creep und die hohe Dielektrizitätskonstante bei gleichzeitig sehr hoher Durchbruchsfeldstärke in ungedehntem Zustand. Mit diesen erfindungsgemäßen Polymerelementen können vorteilhaft besonders günstige Eigenschaften der damit hergestellten elektromechanischen Wandler erzielt werden.

## Patentansprüche

1. Elektromechanischer Wandler aufweisend mindestens zwei Elektroden und mindestens ein elektroaktives Polymerelement, wobei das Polymerelement zwischen zwei Elektroden angeordnet ist,
**dadurch gekennzeichnet dass**
das Polymerelement aus einer Reaktionsmischung umfassend die folgenden Komponenten
A) ein Polyisocyanat
B) ein Polyisocyanat-Prepolymer und
C) eine Verbindung mit mindestens zwei isocyanatreaktiven Hydroxygruppen,
erhältlich ist.

2. Elektromechanischer Wandler nach Anspruch 1, **dadurch gekennzeichnet, dass** dieser ein Sensor und/oder Aktuator und/oder Generator ist.

3. Elektromechanischer Wandler nach Anspruch 1, **dadurch gekennzeichnet, dass** Komponente
A) ein Isocyanuratgruppen- oder Uretdiongruppen-haltiges Polyisocyanat oder eine Mischung hieraus
ist.

4. Elektromechanischer Wandler nach Anspruch 1, **dadurch gekennzeichnet, dass** Komponente
A) ein Diisocyanat mit einer NCO-Funktionalität ≥ 2 mit Uretdion-, Isocyanurat-, Biuret-, Iminooxadiazindion- oder Oxadiazintrionstruktur oder eine Mischung hieraus
ist.

5. Elektromechanischer Wandler nach Anspruch 1, **dadurch gekennzeichnet, dass** Komponente
A) ein Polyisocyanat oder ein Polyisocyanatgemisch mit einer mittleren NCO-Funktionalität von 2 bis 4 mit ausschließlich aliphatisch oder cycloaliphatisch gebundenen Isocyanatgruppen
ist.

6. Elektromechanischer Wandler nach Anspruch 1, **dadurch gekennzeichnet, dass** Komponente
B) ein Reaktionsprodukt aus der Umsetzung von einem oder mehreren Diisocyanaten
mit einem oder mehreren hydroxyfunktionellen Polyolen ist.

7. Elektromechanischer Wandler nach Anspruch 6, **dadurch gekennzeichnet, dass** die Diisocyanate mit hydroxyfunktionellen Polyolen bei einem Verhältnis der Isocyanatgruppen zu Hydroxygruppen von 2:1 bis 20:1 umgesetzt werden.

8. Elektromechanischer Wandler nach Anspruch 1, **dadurch gekennzeichnet, dass** Komponente
C) ein Polyamin oder ein Polyol mit mindestens zwei isocyanatreaktiven Hydroxygruppen
ist.

9. Elektromechanischer Wandler nach Anspruch 1, **dadurch gekennzeichnet, dass** Komponente
C) ein polymeres Polyol
ist.

10. Verfahren zur Herstellung eines elektromechanischen Wandlers nach Anspruch 1, umfassend die folgenden Schritte
a) Bereitstellung von mindestens zwei Elektroden, und
b) Bereitstellung eines Polymerelements durch Umsetzung einer Reaktionsmischung umfassend die folgenden Komponenten
A) ein Polyisocyanat
B) ein Polyisocyanat-Prepolymer und
C) eine Verbindung mit mindestens zwei isocyanatreaktiven Hydroxygruppen,
c) Anordnung des Polymerelements zwischen zwei Elektroden.

11. Verfahren nach Anspruch 10, **dadurch gekennzeichnet, dass** die Bereitstellung des Polymerelements durch Auftragen der Reaktionsmischung auf mindestens eine der Elektroden und Umsetzung der Reaktionsmischung erfolgt.

12. Verfahren nach Anspruch 10 oder 11, **dadurch gekennzeichnet, dass** die Reaktionsmischung aus A), B) und C) getrocknet und/oder getempert wird.

13. Verfahren nach Anspruch 11, **dadurch gekennzeichnet, dass** das eingesetzte Equivalentverhältnis der Isocyanatgruppen aus A) zu den Isocyanatgruppen aus B) zwischen 1:10 und 10:1 liegt.

14. Verwendung eines elektroaktiven Polymerelements, erhältlich aus einer Reaktionsmischung umfassend die folgenden Komponenten
A) ein Polyisocyanat
B) ein Polyisocyanat-Prepolymer erhältlich aus der Umsetzung von einem oder mehreren Diisocyanaten mit einem oder mehreren hydroxyfunktionellen Polyolen und
C) eine Verbindung mit mindestens zwei isocyanatreaktiven Hydroxygruppen,
als elektromechanisches Element.

15. Elektronische und/oder elektrische Vorrichtung umfassend einen elektromechanischen Wandler nach Anspruch 1.

## Claims

1. Electromechanical transducer having at least two electrodes and at least one electroactive polymer element, the polymer element being arranged between two electrodes,
**characterized in that**
the polymer element is obtainable from a reaction mixture comprising the following components
A) a polyisocyanate
B) a polyisocyanate prepolymer and
C) a compound having at least two isocyanate-reactive hydroxyl groups.

2. Electromechanical transducer according to Claim 1, **characterized in that** it is a sensor and/or actuator and/or generator.

3. Electromechanical transducer according to Claim 1, **characterized in that** component
A) is an isocyanurate- or uretdione-containing polyisocyanate or a mixture thereof.

4. Electromechanical transducer according to Claim 1, **characterized in that** component
A) is a diisocyanate having an NCO functionality ≥ 2 with uretdione, isocyanurate, biuret, iminooxadiazinedione or oxadiazinetrione structure or a mixture thereof.

5. Electromechanical transducer according to Claim 1, **characterized in that** component
A) is a polyisocyanate or a polyisocyanate mixture having a mean NCO functionality of 2 to 4 with exclusively aliphatically or cycloaliphatically bonded isocyanate groups.

6. Electromechanical transducer according to Claim 1 **characterized in that** component
B) is a reaction product from the reaction of one or more diisocyanates with one or more hydroxyl-functional polyols.

7. Electromechanical transducer according to claim 6, **characterized in that** the diisocyanates are reacted with hydroxyl functional polyols at a ratio of the isocyanate groups to hydroxyl groups of 2:1 to 20:1

8. Electromechanical transducer according to Claim 1, **characterized in that** component
C) is a polyamine or a polyol having at least two isocyanate-reactive hydroxyl groups.

9. Elactromechanical transducer according to Claim 1, **characterized in that** component
C) is a polymeric polyol.

10. Process for producing an electromechanical transducer a according to Claim 1, comprising the following steps:
a) providing at least two electrodes, and
b) providing a polymer element by converting a reaction mixture comprising the following components;
A) a polyisocyanate
B) a polyisocyanate prepolymer and
C) a compound having at least two isocyanate-reactive hydroxyl groups,
c) arranging the polymer element between two electrodes.

11. Process according to Claim 10, **characterised in that** the polymer element is provided by applying the reaction mixture to at least one of the electrodes and converting the reaction mixture.

12. Process according to Claim 10 or 11, **characterized in that** the reaction mixture of A), B) and C) is dried and/or heat-treated.

13. Prowess according to Claim 11, **characterized in that** the equivalence ratio of the isocyanate groups from A) to the isocyanate groups from B) is between 1:10 and 10:1.

14. Use of an electroactive polymer element obtainable from a reaction mixture comprising the following components:
A) a polyisocyanate
B) a polyisocyanate prepolymer obtainable from the reaction of one or more diisocyanates with one or more hydroxyl-functional polyols and
C) a compound having at least two isocyanate-reactive hydroxyl groups,
as an electromechanical element.

15. Electronic and/or electric device comprising an electromechanical transducer according to Claim 1.

## Revendications

1. Convertisseur électromécanique présentant au moins deux électrode et au moins un élément polymère électroactif, 1 élément polymère étant disposé entre de électrodes **caractérisé en ce que** 1 élément polymère peut être obtenu à partir d'un mélange réactionnel comprenant les composants suivants
A) un polyisocyanate
B) un prépolymère de polyisocyanate et
C) un composé présentant au moins deux groupes hydroxy réactifs avec isocyanate.

2. Convertisseur electromécanique selon la revendication 1 caractérisé en ce q il agit d'un capteur et/ou d'un actionneur et/ou d'un générateur.

3. Convertisseur électromécanique selon la revendication 1 **caractérisé en ce que** le composant
A) est un polyisocyanate contenant des groupes isocyanurate ou uretdione ou un mélange de ceux-ci

4. Convertisseur électromécanique selon la revendication 1 **caractérisé en ce que** le composant
A) est un diisocyanate présentant une fonctionnalité NCO ≥ 2 présentant une structure uretdione, isocyanurate, biuret, iminooxadiazinedione ou oxadiazinetrione ou un mélange de ceux-ci.

5. Convertisseur électromécanique selon la revendication 1, caractérisé en e que le composant
A) est un polyisocyanate ou un mélange de polyisocyanates présentant une fonctionnalité NCO moyenne de 2 à 4 présentant exclusivement des groupes isocyanate liés aliphatiquement ou cycloaliphatiquement.

6. Convertisseur électromécanique selon la revendication 1, **caractérisé en ce que** le composant
B) est un produit de réaction de la transformation d'un ou de plusieurs diisocyanates avec un ou plusieurs polyols à fonctionnalité hydroxy.

7. Convertisseur électromécanique selon la revendication 6, **caractérisé en ce que** les diisocyanates sont transformés avec des polyols à fonctionnalité hydroxy à un rapport des groupes isocyanate à groupes hydroxy de 2:1 à 20:1.

8. Convertisseur électromécanique selon la revendication 1, **caractérisé en ce que** le composant
C) est une polyamine ou un polyol présentant au moins deux groupes hydroxy réactifs avec isocyanate.

9. Convertisseur électromécanique selon la revendication 1, **caractérisé en ce que** le composant
C) est un polyol polymère.

10. Procédé pour la préparation d'un convertisseur électromécanique selon la revendication 1, comprenant les étapes suivantes :
a) préparation d'au moins deux électrodes, et
b) préparation d'un élément polymère par transformation d'un mélange réactionnel comprenant les composants suivants
A) un polyisocyanate
B) un prépolymère de Polyisocyanate et
C) un composé présentant au moins deux groupes hydroxy réactifs avec isocyanate,
c) disposition de l'élément polymère entre deux électrodes.

11. Procédé selon la revendication 10, **caractérisé en ce que** la préparation de l'élément polymère est réalisée par application du mélange reactionnel sur au moins une des électrodes et transformation du mélange réactionnel.

12. Procédé selon la revendication 10 ou 11 **caractérisé en ce que** le mélange réactionnel de A), B) et C) est séché et/ou traite thermiquement.

13. Procédé selon la revendication 11 **caractérisé en ce que** le rapport d'équivalents utilise des groupes isocyanate de A) aux groupes isocyanate de B ect situé entre 1:10 et 10:1.

14. Utilisation d'un élément polymère électroactif, pouvant être obtenu à partir d'un mélange réactionnel comprenant les composants suivants
A) un polyisocyanate
B) un prépolymère de polyisocyanate, pouvant être obtenu à partir de la transformation d'un ou de plusieurs diisocyanates avec un ou plusieurs polyols à fonctionnalité hydroxy et
C) un composé présentant au moins deux groupes hydroxy réactifs avec isocyanate,
comme élément électromécanique.

15. Dispositif électronique et/ou électrique comprenant un convertisseur électromécanique selon la revendication 1.
